# EUROPEAN PATENT SPECIFICATION

(11) **EP 2 387 153 B1**
(45) Date of publication and mention of the grant of the patent: **26.03.2014**
(21) Application number: 11003933.6
(22) Date of filing: 12.05.2011
(51) Int. Cl.: H03K 5/08

(54) **Signal level crossing detector circuit**
Signalpegelüberschreitungsdetektorschaltung
Circuit de détecteur de croisement de niveau de signal

(30) Priority: 12.05.2010 GB 201007896
(43) Date of publication of application: 16.11.2011
(73) Proprietor: Gigle Networks Limited, Edinburgh EH3 9SU (GB)
(72) Inventor: Barnett, Iain, Edinburgh EH3 9SU (GB); Holland, Will, Edinburgh EH3 9SU (GB); Hurwitz, Jonathan Ephraim David, Edinburgh EH3 9SU (GB)
(74) Representative: Jehle, Volker Armin

(56) References cited:
- DE-A1- 3 728 230
- US-A- 4 247 790

## Description

### Field of the invention

The present invention relates to a signal level crossing detector circuit for use in particular but not exclusively in mains voltage powered consumer products.

### Background to the invention

Mains voltage powered consumer products, such as multimedia home networking nodes, are required for reasons of safety to have electrical isolation between mains voltage circuitry and low voltage circuitry. Despite the electrical isolation there is often a need to convey signals across the electrical isolation barrier between the mains voltage circuitry and the low voltage circuitry. The determination of a location in time, such as a zero crossing point, on the mains voltage signal from the low voltage side is an example of such a need involving the conveyance of signals from the high voltage side to the low voltage side. The determination of a location on the mains voltage signal finds application, for example, in providing for synchronisation with a mains voltage cycle. Synchronisation with the mains voltage cycle may be used to provide for synchronised communication between and amongst low voltage circuits of multiple networked products, such as multimedia home networking nodes. A more specific example is the provision of an ISP (Inter-System Protocol) that provides for cooperation between and amongst devices that are operating according to different communications protocols. The ISP involves opening a window once every predetermined number of zero crossings of the mains voltage signal and the sending of a recognised symbol followed by control data that provides for the cooperation. The determination of a location on the mains voltage signal may also find application in monitoring the phase variation of a mains supply to determine whether or not the mains supply is liable to fail. For example, there may be an increased likelihood of failure in supply if there is more than a 2% variation in the phase of a mains supply from a twenty-four hour mean. Precautionary measures may then be taken, such as the engagement of an uninterruptable power supply. According to a more simple application, the determination of a location on the mains voltage signal may be used to determine whether the mains voltage signal is of 50 Hz or 60 Hz. In yet a further application, the determination of a location on the mains voltage signal may be used to adapt the communications channel to optimise channel capacity. More specifically, mains voltage signal location determination may be used as the basis for dividing the mains voltage cycle into parts, with various noise indicative characteristics, such as power level and expected signal to noise ratio, in the different parts being monitored and compared in different communications links. The channel is then adapted in dependence on the comparison of the noise indicative characteristics.

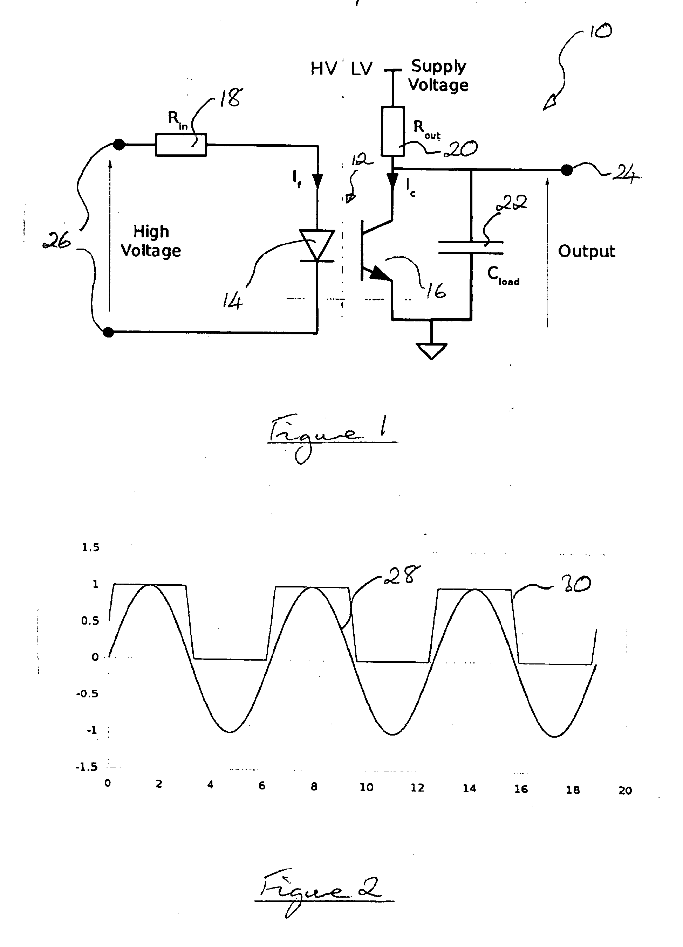

A known electrical isolator circuit 10 for conveying signals from a mains voltage circuit to a low voltage circuit whilst maintaining isolation between the mains and low voltage circuits for subsequent zero-crossing detection is shown in Figure 1. The electrical isolator circuit 10 comprises an opto-isolator 12 having an infrared light emitting diode (LED) 14 and a photo-transistor 16. A resistor, Rin, 18 in series with the LED limits the current flowing through the LED. A load resistor, Rout, 20 is present in series with the photo-transistor 16 between the photo-transistor and the positive power line. A capacitor, Cload, 22 represents a parasitic capacitance of the electrical circuit connected to the output 24 of the photo-transistor. In use, a high voltage AC signal is applied across the inputs 26 to the electrical isolator circuit to thereby cause operation of the LED 14. Light emitted by the LED is received by the photo-transistor and causes a current to flow in the photo-transistor with the current developed across the load resistor to thereby provide a corresponding voltage at the output 24. A representative high voltage AC signal 28 is shown in Figure 2 along with a corresponding output voltage 30 from a zero-crossing detector that takes as its input the voltage signal from the output 24. The high voltage AC signal 28 and the corresponding output voltage 30 are not to scale in Figure 2. More specifically and for example, the high voltage AC signal 28 might be 230 Vrms and the output voltage 30 might be 3.3 volts.

A disadvantage of a zero crossing detector comprising the electrical isolator circuit of Figure 1 is its high power dissipation on the low voltage side and, in particular, on the high voltage side. The temporal accuracy of the output 24 depends on the speed at which the isolator circuit 10 is capable of switching with the switching speed being determined by the RC time constant of Rout and Cload. The maximum value of Rout can be determined for a given load and a desired accuracy. The maximum value of Rout and the required voltage swing in turn determine the minimum required photo-transistor current, Ic. The LED forward current, If, is then determined on the basis of the current transfer ratio (CTR) of the opto-isolator having regards to the photo-transistor current, Ic. For high voltage signals, most of the voltage is dropped across Rin. A power dissipation of 0.5 Watts can be expected for a typical opto-isolator and typical values for Rout and Rin. If the forward current, If, is reduced to a significant extent to reduce the power dissipation there is not only a corresponding reduction in the photo-transistor current but also a reduction in the current transfer ratio of the opto-isolator. The combination of these effects results in a much more significant reduction in the output swing, which necessitate an increase in Rout, which in turn decreases the switching speed of the isolator circuit by a corresponding amount. Hence, a zero crossing detector comprising the electrical isolator circuit of Figure 1 presents an unacceptable compromise between power dissipation and switching speed.

The present invention has been devised in the light of the above mentioned problem with known zero-crossing detector circuits.

It is therefore an object for the present invention to provide a signal level crossing detector circuit, e.g. a zero crossing detector circuit, comprising a DC isolator circuit.

It is a further object for the present invention to provide a signal level crossing detector circuit, which comprises a DC isolator circuit, and which is operable to detect when a high voltage AC signal crosses a predetermined signal level.

### Statement of invention

According to a first aspect of the present invention there is provided a signal level crossing detector circuit comprising:
a DC isolator comprising at least a first input, which is configured to receive a high voltage AC signal, and at least a first capacitor, a first plate of the first capacitor being electrically connected to the first input; and
a detector circuit operable at a low voltage and having at least a first detector input, the first detector input being electrically connected to a second plate of the first capacitor, the low voltage detector circuit being operable to provide a change in output signal in dependence on a high voltage AC signal on the first input crossing a predetermined signal level.

DE 37 28 230 A1 describes a circuit for detecting an inbound call signal in a telecommunications device. The device comprises at its input a series of a blocking capacitor and an ohmic resistor and the input of a photocoupler and a non-linear component. In case the amplitude of an inbound signal falls below a threshold voltage of the non-linear component, the discriminating circuit on the secondary side of the photocoupler will not detect the incoming signal, since the photocoupler does not pass that signal to its output.

US 4,247,790 describes a failsafe signal voltage threshold determining apparatus for operation in a train vehicle control system, which utilizes a forward voltage drop characteristic of an input light emitting diode of an optical isolator device as a train vehicle control signal threshold reference. The detector transistor of the optical isolator device provides an output control signal in response to an input train vehicle control signal applied to the light emitting diode which has a voltage level high enough to overcome the light emitting diode voltage drop.

In use, the DC isolator of the signal level crossing detector circuit is operative to couple a high voltage AC signal to a detector circuit that is operable at a low voltage. The detector circuit is operative to provide a change in low voltage output signal when the high voltage AC signal crosses a predetermined signal level. Hence, the signal level crossing detector circuit may be used to determine when the high voltage AC signal crosses a predetermined signal level, such as a zero crossing point, with the determination being used to provide for synchronisation with a mains voltage cycle. Such synchronisation may be of benefit, for example, where the signal level crossing detector circuit is present in each of a plurality of nodes in a multimedia home network to provide for synchronisation between and amongst the nodes of the network. The DC isolator circuit normally has a lower power dissipation than the opto-isolator circuit of Figure 1 on account of the large impedance presented by the at least first capacitor at the low frequencies typical of mains AC signals. More specifically, substantially no power is consumed when the circuit is disabled and less power is consumed when the circuit is operative.

More specifically, the DC isolator may be a differential DC isolator comprising first and second inputs and outputs and first and second capacitors, the first and second inputs being configured to receive the high voltage AC signal, a first plate of the first capacitor being electrically connected to the first input and a second opposing plate of the first capacitor being electrically connected to the first output, a first plate of the second capacitor being electrically connected to the second input and a second opposing plate of the second capacitor being electrically connected to the second output. In addition, the detector circuit may be a differential detector having first and second detector inputs, the first detector input being electrically connected to the first output from the DC isolator and the second detector input being electrically connected to the second output from the DC isolator. Hence, the detector may be operative to detect when the signals applied to the first and second inputs to the DC isolator cross each other.

More specifically, the signal level crossing detector circuit may further comprise a load impedance electrically connected in series with the first and second capacitors. The load impedance may have first and second connections, the first connection being electrically connected to the first output from the DC isolator and the second connection being electrically connected to the second output from the DC isolator. Hence, the first capacitor, the load impedance and the second capacitor may be operative as a voltage divider with a reduced level of signal developed across the load impedance and with the reduced level of signal being applied to the inputs of the detector circuit. Thus, the voltage divider may be operative to reduce the high voltage AC signal to a level compatible with the low voltage detector circuit.

More specifically, the load impedance may comprise a parasitic impedance. The parasitic impedance may be formed at an input to the detector circuit, for example between the inverting and non-inverting inputs of a comparator where the comparator is comprised in the detector circuit. Alternatively or in addition, the parasitic impedance may be formed by a printed circuit board. A load impedance in the form of a capacitor may have a capacitance of less than substantially 500 pF, such as substantially 200 pF. More specifically, the load capacitance may be less than substantially 200 pF, such as 15 to 20 pF. Where such a load capacitance is insufficient to achieve a desired voltage division, the load impedance may comprise at least one of a parasitic impedance, e.g. resistance and/or capacitance, and a discrete impedance, such as is provided by a discrete capacitor.

Alternatively or in addition, the load impedance may comprise a third capacitor. At least one of the first, second and third capacitors may have a capacitance of less than 100 pF. More specifically, each of the first and second capacitors may have a capacitance of less than 50 pF. More specifically, each of the first and second capacitors may have a capacitance of less than 10 pF, such as substantially 5 pF. As regards power dissipation, substantially no power is dissipated in the capacitors.

At least one of the first and second capacitors may be a discrete capacitor, such as a Class X or Y capacitor. The third capacitor may be a discrete capacitor, such as a ceramic capacitor.

Alternatively or in addition, the first and second plates of at least one of the first, second and third capacitors may be defined by conductive layers of a printed circuit board and the dielectric of the at least one capacitor may be defined by a non-conducting part of the printed circuit board.

More specifically, at least one plate of a capacitor may be defined by a layer of metal in or on the printed circuit board. The layer of metal may be formed on a surface, such as an upper or lower surface of the printed circuit board. Hence, first and second plates of a capacitor may be formed on opposing upper and lower surfaces of the printed circuit board such that the non-conducting body of the printed circuit board constitutes the dielectric of the capacitor. Alternatively, at least one layer of metal may be embedded within the printed circuit board. Hence, the first and second plates of a capacitor may be formed within the printed circuit board such that they are spaced apart from each other and with their footprints overlapping, whereby a non-conducting part of the printed circuit board between the first and second plates constitutes the dielectric of the capacitor. The first and second plates may share substantially the same footprint.

In a form of the invention, the first plate of the first capacitor may be defined by a first surface layer on a first surface of the printed circuit board, the first plate of the second capacitor may be defined by a second surface layer on a second opposite surface of the printed circuit board, the second plate of the first capacitor may be defined by a first embedded layer within the printed circuit board and the second plate of the second capacitor may be defined by a second embedded layer having a footprint that overlaps a footprint of the first embedded layer, the first and second embedded layers being spaced apart from each other. Footprints of the first and second surface layers may at least partially overlap the footprints of the first and second embedded layers. Also, the second plate of the first capacitor may be closer to the first plate of the first capacitor than the second plate of the second capacitor. Thus, a first plate of the third capacitor may be defined by the first embedded layer and the second plate of the third capacitor may be defined by the second embedded layer with a dielectric of the third capacitor being defined by a non-conducting part of the printed circuit board between the first and second embedded layers. The first and second embedded layers may be spaced apart from each other to an extent less than a spacing between each of the first surface layer and the first embedded layer and of the second surface layer and the second embedded layer. Hence, the third capacitor may have a larger capacitance than each of the first capacitor and the second capacitor.

Alternatively or in addition, the load impedance may comprise a resistor. The resistor may have a resistance of more than 1 M Ohm. More specifically, the resistor may have a resistance of substantially 10 M Ohm.

Alternatively or in addition, the signal level crossing detector circuit may further comprise a first active circuit, which is connected between the first output from the DC isolator and a first predetermined voltage level. In addition, the signal level crossing detector circuit may comprise a second active circuit, which is connected between the second output from the DC isolator and a second predetermined voltage level. An active circuit may be operative to pull its respective output from the DC isolator between its respective predetermined voltage level and a respective active circuit voltage level. The first and second predetermined voltage levels may be substantially the same, such as zero volts. The respective active circuit voltage level may be determined by a threshold voltage of the active circuit. An active circuit may comprise first and second diodes in a back to back configuration. The first and second diodes may be formed in an integrated circuit, e.g. as part of a pad Electrostatic Discharge (ESD) protection or otherwise purpose formed. Where the first and second diodes are formed in an integrated circuit, they may be so formed with the detector circuit. Alternatively, the first and second diodes may be formed as discrete circuits. Hence, the first and second diodes may be operative in a first form of signal level crossing detector circuit comprising a capacitive divider circuit to provide for ESD protection. The active circuit may be operative in a second form of signal crossing detector lacking a capacitive divider circuit to pull its respective output from the DC isolator between its respective predetermined voltage level and a respective active circuit voltage level to thereby provide for detection of crossing of the predetermined signal level.

Alternatively or in addition, the DC isolator may have a single ended configuration. Hence, the DC isolator may comprise solely a first input, which is configured to receive the high voltage AC signal, and solely a first capacitor.

More specifically, the signal level crossing detector circuit may further comprise a load impedance electrically connected in series with the first capacitor. The load impedance may have first and second connections, the first connection being electrically connected to the first output from the DC isolator and the second connection being electrically connected to a predetermined voltage, such as ground. Hence, the first capacitor and the load impedance may be operative as a voltage divider with a reduced level of signal developed across the load impedance and with the reduced level of signal being applied to the inputs of the detector circuit. Thus, the voltage divider may be operative to reduce the high voltage AC signal to a level compatible with the low voltage detector circuit. More specifically, the load impedance may comprise a second capacitor. Alternatively or in addition, the load impedance may comprise a resistor.

Alternatively or in addition, the detector circuit may comprise a comparator. Where the DC isolator is of a differential configuration, the first output from the DC isolator may be electrically connected to the non-inverting input of the comparator and the second output from the DC isolator may be electrically connected to the inverting input of the comparator. Where the DC isolator is single ended, the first output (i.e. the sole output) from the DC isolator may be electrically connected to the non-inverting input of the comparator and the inverting input of the comparator may be electrically connected to a predetermined voltage level, e.g. ground. Thus, an output from the comparator may switch between a high voltage level and a low voltage level when the predetermined voltage level is crossed. The high voltage level and low voltage level may, for example, be at or near the high and low supply voltages for the comparator.

Alternatively or in addition, the detector circuit may further comprise a timer that is operative in dependence on the change of output signal. The change in output signal occurs in dependence on the high voltage AC signal on the first input crossing the predetermined signal level. The timer may be configured to determine a period of time between successive crossings of the predetermined signal level by the high voltage AC signal. Alternatively or in addition, the timer may be configured to determine an absolute time when the predetermined signal level is crossed by the high voltage AC signal.

Alternatively or in addition, the at least one input to the DC isolator may be configured to receive a high voltage AC signal having a frequency of less than 500 Hz, such as a frequency of substantially 60 Hz or substantially 50 Hz for domestic mains or a frequency of substantially 400 Hz for mains in ships.

Alternatively or in addition, a high voltage AC signal in the context of the present invention may be an AC voltage of 50 Vrms or greater according to standards defined by the International Electrotechnical Commission, such as an AC voltage of substantially 110 Vrms or substantially 230 Vrms. Thus, the high voltage AC signal may be a domestic mains voltage signal or a mains voltage signal in a ship.

Alternatively or in addition, a low voltage signal in the context of the present invention may be an AC voltage of less than 50 Vrms or a DC voltage of less than 120 V according to standards defined by the International Electrotechnical Commission. More specifically, the low voltage signal may be a DC voltage of less than substantially 15 volts, such as a voltage of 12 volts. More specifically, the low voltage signal may be a DC voltage of substantially 5 volts or less, such as 3 volts.

According to a second aspect of the present invention, there is provided an integrated circuit comprising the signal level crossing detector circuit according to the first aspect of the present invention. The integrated circuit may be configured to form part of a home networking node.

Embodiments of the second aspect of the present invention may comprise one or more features of the first aspect of the present invention.

According to an aspect of the invention, a signal level crossing detector circuit comprises:
a DC isolator comprising at least a first input, which is configured to receive a high voltage AC signal, and at least a first capacitor, a first plate of the first capacitor being electrically connected to the first input; and
a detector circuit operable at a low voltage and having at least a first detector input, the first detector input being electrically connected to a second plate of the first capacitor, the low voltage detector circuit being operable to provide a change in output signal in dependence on a high voltage AC signal on the first input crossing a predetermined signal level.

Advantageously, the DC isolator is a differential DC isolator comprising first and second inputs and outputs and first and second capacitors, the first and second inputs being configured to receive the high voltage AC signal, a first plate of the first capacitor being electrically connected to the first input and a second opposing plate of the first capacitor being electrically connected to the first output, a first plate of the second capacitor being electrically connected to the second input and a second opposing plate of the second capacitor being electrically connected to the second output.

Advantageously, the detector circuit is a differential detector having first and second detector inputs, the first detector input being electrically connected to the first output from the DC isolator and the second detector input being electrically connected to the second output from the DC isolator.

Advantageously, the signal level crossing detector circuit further comprises a load impedance electrically connected in series with the first and second capacitors, the load impedance having first and second connections, the first connection being electrically connected to the first output from the DC isolator and the second connection being electrically connected to the second output from the DC isolator.

Advantageously, the load impedance comprises a parasitic impedance.

Advantageously, the load impedance when in the form of a capacitor has a capacitance of less than substantially 500 pF.

Advantageously, the capacitance is between substantially 15 pF and substantially 20 pF.

Advantageously, the load impedance comprises at least one of a parasitic impedance and an impedance provided by a discrete component.

Advantageously, the load impedance comprises a third capacitor.

Advantageously, at least one of the first, second and third capacitors has a capacitance of less than 100 pF.

Advantageously, each of the first and second capacitors has a capacitance of less than 10 pF.

Advantageously, at least one of the first and second capacitors is a discrete Class X or Y capacitor and the third capacitor is a discrete ceramic capacitor.

Advantageously, the first and second plates of at least one of the first, second and third capacitors is defined by conductive layers of a printed circuit board and the dielectric of the at least one capacitor is defined by a non-conducting part of the printed circuit board.

Advantageously, at least one plate of a capacitor is defined by a layer of metal in or on the printed circuit board.

Advantageously, first and second plates of a capacitor are formed on opposing upper and lower surfaces of the printed circuit board such that the non-conducting body of the printed circuit board constitutes the dielectric of the capacitor.

Advantageously, at least one layer of metal is embedded within the printed circuit board.

Advantageously, the first plate of the first capacitor is defined by a first surface layer on a first surface of the printed circuit board, the first plate of the second capacitor is defined by a second surface layer on a second opposite surface of the printed circuit board, the second plate of the first capacitor is defined by a first embedded layer within the printed circuit board and the second plate of the second capacitor is defined by a second embedded layer having a footprint that overlaps a footprint of the first embedded layer, the first and second embedded layers being spaced apart from each other.

Advantageously, the second plate of the first capacitor is closer to the first plate of the first capacitor than the second plate of the second capacitor.

Advantageously, the first and second embedded layers are spaced apart from each other to an extent less than a spacing between each of the first surface layer and the first embedded layer and of the second surface layer and the second embedded layer.

Advantageously, the load impedance comprises a resistor.

Advantageously, the resistor has a resistance of more than 1 M Ohm.

Advantageously, the signal level crossing detector circuit further comprises a first active circuit, which is connected between the first output from the DC isolator and a first predetermined voltage level.

Advantageously, the signal level crossing detector circuit comprises a second active circuit, which is connected between the second output from the DC isolator and a second predetermined voltage level.

Advantageously, an active circuit is operative to pull its respective output from the DC isolator between its respective predetermined voltage level and a respective active circuit voltage level.

Advantageously, the respective active circuit voltage level is determined by a threshold voltage of the active circuit.

Advantageously, an active circuit comprises first and second diodes in a back to back configuration.

Advantageously, the DC isolator has a single ended configuration, with the DC isolator comprising solely a first input, which is configured to receive the high voltage AC signal, and solely a first capacitor.

Advantageously, the signal level crossing detector circuit further comprises a load impedance electrically connected in series with the first capacitor, the load impedance having first and second connections, the first connection being electrically connected to the first output from the DC isolator and the second connection being electrically connected to a predetermined voltage.

Advantageously, the load impedance comprises at least one of: a second capacitor; and a resistor.

Advantageously, the detector circuit comprises a comparator.

Advantageously, the DC isolator is of a differential configuration, in which the first output from the DC isolator is electrically connected to the non-inverting input of the comparator and the second output from the DC isolator is electrically connected to the inverting input of the comparator.

Advantageously, the DC isolator is single ended, in which the sole output from the DC isolator is electrically connected to the non-inverting input of the comparator and the inverting input of the comparator is electrically connected to a predetermined voltage level.

Advantageously, the detector circuit further comprises a timer that is operative in dependence on the change of output signal, the timer being configured to one of: determine a period of time between successive crossings of the predetermined signal level by the high voltage AC signal and determine an absolute time when the predetermined signal level is crossed by the high voltage AC signal.

Advantageously, the at least one input to the DC isolator is configured to receive a high voltage AC signal having a frequency of less than 500 Hz.

Advantageously, a high voltage AC signal is an AC voltage of 50 Vrms or greater according to standards defined by the International Electrotechnical Commission.

Advantageously, a low voltage signal is an AC voltage of less than 50 Vrms or a DC voltage of less than 120 V according to standards defined by the International Electrotechnical Commission.

### Brief description of drawings

Further features and advantages of the present invention will become apparent from the following specific description, which is given by way of example only and with reference to the accompanying drawings, in which:
Figure 1 is a circuit diagram of a known electrical isolator circuit;
Figure 2 is a graphical representation of input and output voltages for the circuit of Figure 1;
Figure 3A is a circuit diagram of a first embodiment of signal level crossing detector circuit according to the present invention;
Figure 3B is a graphical representation of input and output voltages for the circuit of Figure 3A;
Figure 4 is a circuit diagram of a second embodiment of signal level crossing detector circuit according to the present invention;
Figure 5 is a circuit diagram of a third embodiment of signal level crossing detector circuit according to the present invention;
Figure 6 is a circuit diagram of a fourth embodiment of signal level crossing detector circuit according to the present invention;
Figure 7 is a circuit diagram of a fifth embodiment of signal level crossing detector circuit according to the present invention;
Figure 8 provides plan and cross-section views of a capacitor forming part of a signal level crossing detector circuit according to the present invention;
Figure 9A is a circuit diagram of a capacitance divider forming part of the circuit of Figure 3A; and
Figure 9B provides a cross-section view of a printed circuit board configured to form the circuit of Figure 9A.

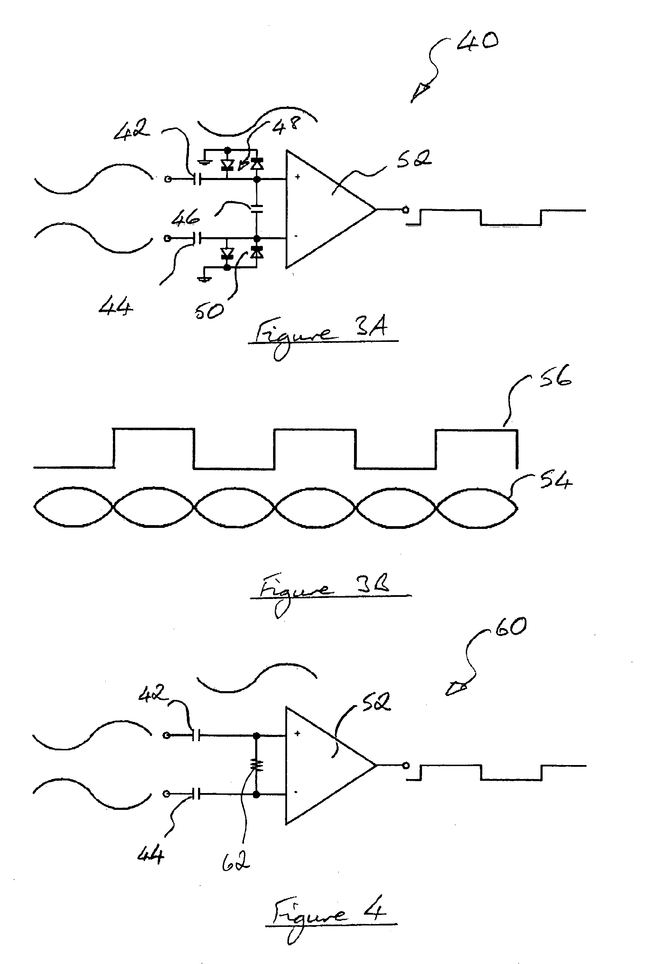

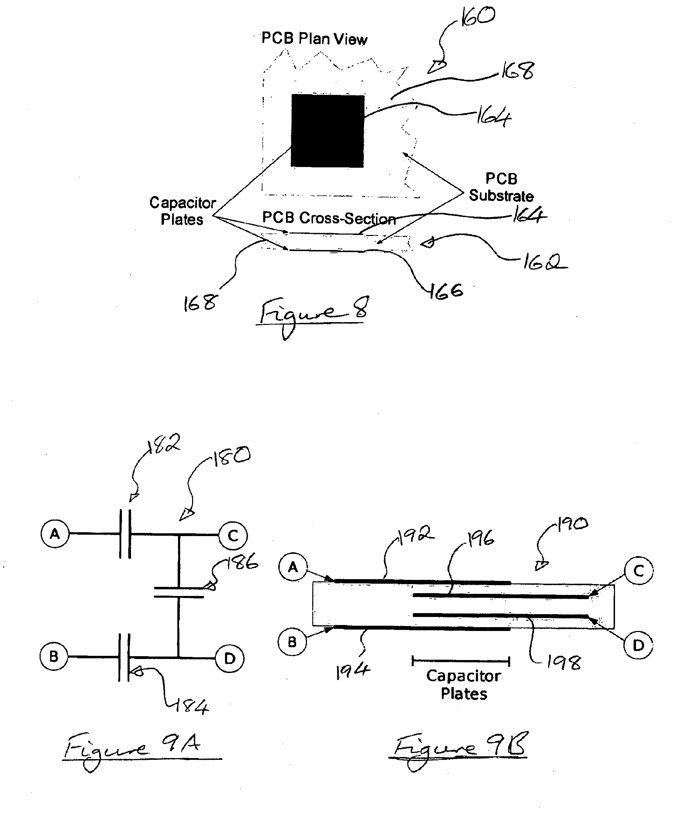

A first embodiment of signal level crossing detector circuit 40 is shown in Figure 3A. The signal level crossing detector circuit 40 comprises first 42, second 44 and third 46 series connected capacitors, a first 48 and a second 50 pair of back to back diodes and a comparator 52. The first and second capacitors 42, 44 constitute a DC isolator. A first plate of the first capacitor 42 constitutes a first input to the DC isolator and a first plate of the second capacitor 44 constitutes a second input to the DC isolator. Although not shown in Figure 3A, a voltage source operative to provide a domestic mains signal, such as 230 Vrms at 50 Hz, to the first and second inputs. The second plate of the first capacitor 42 is electrically connected to the non-inverting input of the comparator 52 and to a first plate of the third capacitor 46. The second plate of the second capacitor 44 is electrically connected to the inverting input of the comparator 52 and to a second plate of the third capacitor 46. Hence, the series connected first to third capacitors function as a capacitive divider with a reduced amplitude signal being developed across the third capacitor 46 in response to application of the mains signal to the first and second inputs. Hence, the comparator 52 is operative to switch its output between a high output level and a low output level in dependence on the voltage levels of the mains input signals crossing each other. The operation of the circuit of Figure 3A is illustrated in Figure 3B, which shows the mains input signals 54 and the corresponding output from the comparator. As can be seen from Figure 3B, the comparator output switches when the mains input signals cross each other. Although not shown in Figure 3A, the comparator output gates a timer whereby the time period from one crossing to the next is determined. Alternatively the comparator output triggers the reading of a time signal from a real time clock or the like to thereby determine the absolute time when a crossing occurs. The design of such a timer or real time clock is within the scope of the ordinary design capabilities of the skilled person. The first 48 and a second 50 pairs of back to back diodes provide for ESD protection on the low voltage side of the DC isolator formed by the first and second capacitors 42, 44. The first, second and third capacitors 42, 44, 46 are discrete capacitors, such as Class X or Y capacitors for the first and second capacitors and a ceramic capacitor for the third capacitor, or are formed as part of a printed circuit board on which the comparator and other electronic circuitry is mounted, as is described below with reference to Figures 8, 9A and 9B. Alternatively, the third capacitor 46 is defined by a parasitic capacitance present at the input to the comparator 52 or found elsewhere on the printed circuit board.

A second embodiment of signal level crossing detector circuit 60 is shown in Figure 4. Components in common with the first embodiment of Figure 3A are indicated with common reference numerals. Hence, the circuit of Figure 4 comprises a DC isolator formed from first and second capacitors 42, 44 and a comparator 52 having a non-inverting input electrically connected to the second plate of the first capacitor 42 and an inverting input electrically connected to the second plate of the second capacitor 44. A resistor 62 is electrically connected across the non-inverting and inverting inputs of the comparator 52 instead of the third capacitor 46 of Figure 3A. Hence, the first and second capacitors 42, 44 and resistor 62 form a voltage divider with a reduced amplitude signal being developed across the resistor in response to application of a mains signal to the first and second inputs. Otherwise the circuit of Figure 4 is operative in the same fashion as the circuit of Figure 3A such that the comparator 52 switches its output between a high output level and a low output level in dependence on the voltage levels of the mains input signals crossing each other. As with the circuit of Figure 3A, the output of the comparator of the circuit of Figure 4 gates a timer or is operative to trigger the reading of a time signal from a real time clock.

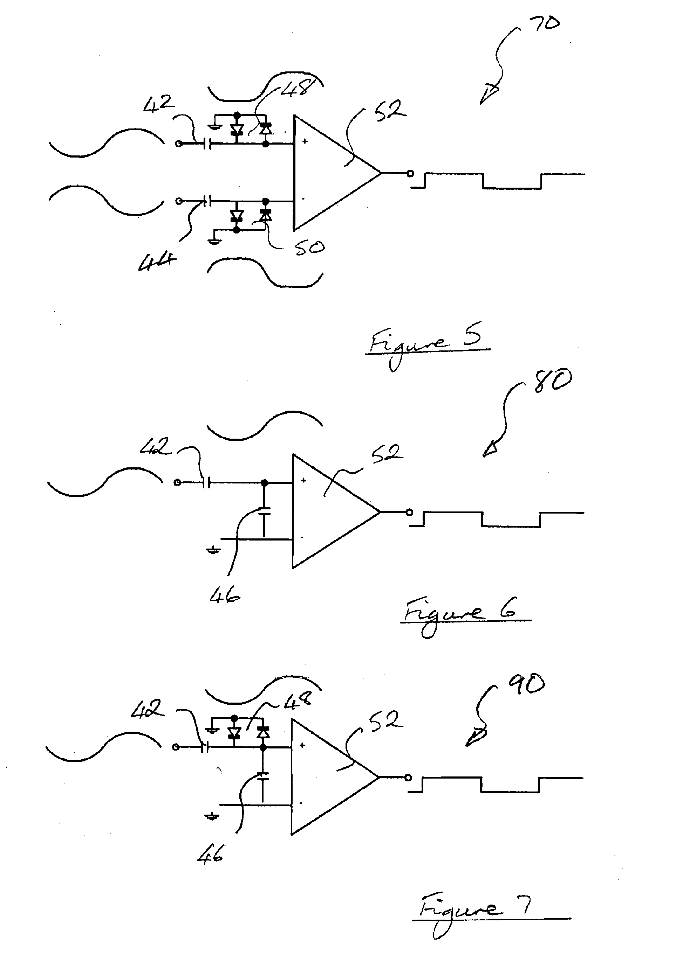

A third embodiment of signal level crossing detector circuit 70 is shown in Figure 5. Components in common with the first embodiment of Figure 3A are indicated with common reference numerals. Hence, the circuit of Figure 5 comprises a DC isolator formed from first and second capacitors 42, 44 and a comparator 52 having a non-inverting input electrically connected to the second plate of the first capacitor 42 and an inverting input electrically connected to the second plate of the second capacitor 44. Instead of the third capacitor 46 of the circuit of Figure 3A between the non-inverting and inverting inputs to the comparator, the circuit of Figure 5 comprises a load to ground at each of the non-inverting and inverting inputs to the comparator. Each load has the form of a pair of back to back diodes 48, 50. As can be seen from the waveforms above the first pair of back to back diodes 48 and below the second pair of back to back diodes 50, the back to back diode pairs are operative to cause the voltage at each of the non-inverting and inverting inputs to the comparator 52 to swing between and saturate at each of a threshold voltage of a first of the diodes above ground and a threshold voltage of a second of the diodes below ground. In dependence on the changing voltage levels at the inputs to the comparator, the comparator 52 switches its output between a high output level and a low output level in dependence on the voltage levels of the mains input signals crossing each other. As with the circuit of Figure 3A, the output of the comparator of the circuit of Figure 5 gates a timer or is operative to trigger the reading of a time signal from a real time clock.

Embodiments of differential signal level crossing detector circuits have been described above with reference to Figures 3A, 4 and 5. Embodiments of single ended signal level crossing detector circuits will now be described with reference to Figures 6 and 7.

A fourth embodiment of signal level crossing detector circuit 80 is shown in Figure 6. Components in common with the first embodiment of Figure 3A are indicated with common reference numerals. The circuit 80 of Figure 6 comprises a first capacitor 42, which receives a mains voltage signal, and which is electrically connected to the non-inverting input of a comparator 52. The inverting input of the comparator 52 is connected to ground. A third capacitor 46 is connected across the non-inverting and inverting inputs to the comparator. Hence, the first and third capacitors are operative as a divider with a reduced amplitude signal being developed across the third capacitor and applied to the non-inverting and inverting inputs to the comparator. In use, the comparator of the circuit of Figure 6 is operative such that its output voltage switches between a high output level and a low output level in dependence on the voltage level of the mains input signals crossing the predetermined voltage at the inverting input, i.e. ground. As with the circuit of Figure 3A, the output of the comparator of the circuit of Figure 6 gates a timer or is operative to trigger the reading of a time signal from a real time clock.

A fifth embodiment of signal level crossing detector circuit 90 is shown in Figure 7. Components in common with the forth embodiment of Figure 6 are indicated with common reference numerals. The circuit 90 of Figure 7 is the same as the circuit of Figure 6 with the following exception. A pair of back to back diodes 48 is connected between the non-inverting input to the comparator 52 and ground. The back to back diodes 48 provide ESD protection on the low voltage side of the DC isolator formed by the first capacitor. Otherwise the circuit of Figure 7 operates in the same fashion as the circuit of Figure 6.

Plan 160 and cross-section 162 views of one of the first, second or third capacitors of Figure 3A are shown in Figure 8. As can be seen, each of the first 164 and second 166 plates of the capacitor are defined by respective metal layers on the top and bottom surfaces of the printed circuit board. The metal layers are disposed such that they share the same footprint and so that the non-conductive substrate 168 of the printed circuit board defines the dielectric of the capacitor. The formation of metal tracks and of larger area structures, such the metal layers of the first and second plates, on a printed circuit board substrate is a process that is well known to the skilled person. Alternatively, one or more capacitor plates are defined by metal layers embedded within the substrate. The provision of embedded metal tracks and of larger area structures, such the metal layers of the first and second plates, is a process that is well known to the skilled person. An application of embedded metal layers is described below with reference to Figures 9A and 9B.

In use, a domestic mains signal is applied to the inputs to the circuit of Figure 3A. The configuration of the first 42 and second 44 capacitors is such that they form a potential divider with the third capacitor 46 to provide an attenuated representation of the domestic mains voltage signal across the third capacitor. For a domestic mains voltage signal of 230 Vrms at 50 Hz, a value of substantially 5 pF is used for each of the first and second capacitors along with a third capacitor having a capacitance of substantially 200 pF to provide an attenuated voltage swing across the third capacitor of about 3 volts.

Figure 9A shows a capacitive divider forming part of the circuit of Figure 3A having first 182 and second 184 capacitors and a third capacitor 186. As can be seen from the cross section view of the printed circuit board 190 shown in Figure 9B, the first plate of the first capacitor 182 is defined by a first surface layer 192 on a first surface of the printed circuit board 190. The first plate of the second capacitor 184 is defined by a second surface layer 194 on a second opposite surface of the printed circuit board 190. The second plate of the first capacitor 182 is defined by a first embedded layer 196 within the printed circuit board and the second plate of the second capacitor is defined by a second embedded layer 198 having a footprint that overlaps a footprint of the first embedded layer. The first and second embedded layers 196, 198 are spaced apart from each other. Footprints of the first and second surface layers 192, 194 partially overlap the footprints of the first and second embedded layers 196, 198. Also, the second plate of the first capacitor 196 is closer to the first plate of the first capacitor 192 than the second plate of the second capacitor 198 is to the first plate of the first capacitor 192. Thus, the third capacitor comprises first and second plates defined by the first and second embedded layers 196, 198 with the dielectric being defined by the part of the substrate between the first and second embedded layers 196, 198. The first 196 and second 198 embedded layers are spaced apart from each other to an extent less than a spacing between each of the first surface layer 192 and the first embedded layer 196 and of the second surface layer 194 and the second embedded layer 198. Hence, the third capacitor has a larger capacitance than each of the first capacitor and the second capacitor. As described in the immediately preceding paragraph, the object is to reduce the mains voltage signal of 230 Vrms to a swing of 3 volts. A value of substantially 5 pF is used for each of the first and second capacitors. In one form, a printed circuit board formed according to normal production practices provides a third capacitance of substantially 15pF to substantially 20 pF. Hence, the required 200 pF capacitance is achieved by using at least one of a parasitic component and an additional discrete component, such as a surface mounted capacitor, diode, etc. Where a parasitic component is used it may be in the form of at least one of parasitic capacitance and parasitic resistance. For example, if a parasitic resistance of 10M Ohms is used with first and second capacitance of 5 pF, the cut-off frequency (3 dB point) is about 3 kHz. Assuming a roll-off of 20 dB per decade, 50 Hz takes us two decades down. Hence, there is a division of about 100 at 50 Hz. The values for the capacitance and resistance can be changed in accordance with ordinary design practice to achieve a desired division factor and to operate with a specific mains frequency. In another form, the normal printed circuit board manufacturing process is modified, e.g. by increasing the number of layers or by including special thinned layers, etc., to thereby increase the third capacitance and decrease the capacitance of the first and second capacitors. Hence, the relative capacitance values can be determined to effect a desired voltage division.

The embodiments of the present invention described above find application in each node of a multimedia home network. As discussed above, detection of the crossing of the mains voltage signal is used, amongst other things, to provide for synchronisation between and amongst the network nodes. An embodiment of the present invention is formed as an integrated circuit that also comprises a home networking integrated circuit, such as a modified form of a GGL541 home networking integrated circuit from Gigle Networks Ltd of Capital House, 2 Festival Square, Edinburgh, EH3 9SU, UK.

## Claims

1. A signal level crossing detector circuit (40, 60, 70) comprising:
a DC isolator comprising at least a first input, which is configured to receive a high voltage AC signal, and at least a first capacitor (42), a first plate of the first capacitor (42) being electrically connected to the first input; and
a detector circuit (52) operable at a low voltage and having at least a first detector input, the first detector input being electrically connected to a second plate of the first capacitor (42), the low voltage detector circuit (52) being operable to provide a change in output signal in dependence on a high voltage AC signal on the first input crossing a predetermined signal level,
**characterized in that**
the DC isolator is a differential DC isolator comprising a second capacitor (44), wherein a first plate of the second capacitor (44) being electrically coupled to the second input of the DC isolator and a second opposing plate of the second capacitor (44) being electrically connected to a second output.

2. The signal level crossing detector circuit (52) of claim 1, in which the detector circuit (52) is a differential detector having first and second detector inputs, the first detector input being electrically connected to the first output from the DC isolator and the second detector input being electrically connected to the second output from the DC isolator.

3. The signal level crossing detector circuit (52) of claim 2, in which the signal level crossing detector circuit (52) further comprises a load
impedance (62) electrically connected in series with the first and second capacitors (42, 44), the load impedance (62) having first and second connections, the first connection being electrically connected to the first output from the DC isolator and the second connection being electrically connected to the second output from the DC isolator.

4. The signal level crossing detector circuit of claim 3, in which the load impedance comprises a parasitic impedance.

5. The signal level crossing detector circuit of claim 3 or 4, in which the load impedance when in the form of a capacitor has a capacitance of less than substantially 500 pF.

6. The signal level crossing detector circuit of claim 5, in which the capacitance is between substantially 15 pF and substantially 20 pF.

7. The signal level crossing detector circuit of any one of claims 3 to 6, in which the load impedance comprises at least one of a parasitic impedance and an impedance (46) provided by a discrete component.

8. The signal level crossing detector circuit of any one of claims 3 to 7, in which the load impedance comprises a third capacitor (46).

9. The signal level crossing detector circuit of claim 8, in which at least one of the first, second and third capacitors (42, 44, 46) has a capacitance of less than 100 pF.

10. The signal level crossing detector circuit of claim 8, in which each of the first and second capacitors (42, 44, 46) has a capacitance of less than 10 pF.

11. The signal level crossing detector circuit of any one of claims 8 to 10, in which at least one of the first and second capacitors (42, 44) is a discrete Class X or Y capacitor and the third capacitor (46) is a discrete ceramic capacitor.

12. The signal level crossing detector circuit of any one of claims 8 to 11, in which the first and second plates of at least one of the first (42), second (44) and third (46) capacitors is defined by conductive layers of a printed circuit board and the dielectric of the at least one capacitor is defined by a non-conducting part of the printed circuit board.

13. The signal level crossing detector circuit of claim 12, in which at least one plate of a capacitor (42, 44, 46) is defined by a layer of metal in or on the printed circuit board.

14. An integrated circuit comprising the signal level crossing detector circuit (40, 60, 70) according to any preceding claim.

## Patentansprüche

1. Signalpegelüberschreitungsdetektorschaltung (40, 60, 70), die umfasst:
- einen Gleichstromisolator, der wenigstens einen ersten Eingang, welcher dafür konfiguriert ist, ein Hochspannungs-Wechselstromsignal zu empfangen, und wenigstens einen ersten Kondensator (42) umfasst, wobei eine erste Platte des ersten Kondensators (42) mit dem ersten Eingang elektrisch verbunden ist, und
- eine Detektorschaltung (52), die bei einer niedrigen Spannung betriebsfähig ist und wenigstens einen ersten Detektoreingang aufweist, wobei der erste Detektoreingang mit einer zweiten Platte des ersten Kondensators (42) elektrisch verbunden ist, wobei die Niedrigspannung-Detektorschaltung (52) betriebsfähig dafür ausgelegt ist, eine Änderung des Ausgangssignals in Abhängigkeit davon bereitzustellen, dass ein Hochspannungs-Wechselstromsignal am ersten Eingang einen vorgegebenen Signalpegel überschreitet,
**dadurch gekennzeichnet, dass**
- der Gleichstromisolator ein Differenz-Gleichstromisolator ist, der einen zweiten Kondensator (44) umfasst, wobei eine erste Platte des zweiten Kondensators (44) mit dem zweiten Eingang des Gleichstromisolators elektrisch verbunden ist und eine zweite gegenüberliegende Platte des zweiten Kondensators (44) mit einem zweiten Ausgang elektrisch verbunden ist.

2. Signalpegelüberschreitungsdetektorschaltung (52) nach Anspruch 1, wobei die Detektorschaltung (52) ein Differenzdetektor mit einem ersten und einem zweiten Detektoreingang ist, wobei der erste Detektoreingang mit dem ersten Ausgang des Gleichstromisolators und der zweite Detektoreingang mit dem zweiten Ausgang des Gleichstromisolators elektrisch verbunden ist.

3. Signalpegelüberschreitungsdetektorschaltung (52) nach Anspruch 2, wobei die Signalpegelüberschreitungsdetektorschaltung (52) ferner eine Lastimpedanz (62) umfasst, die mit dem ersten und dem zweiten Kondensator (42, 44) elektrisch in Reihe geschaltet ist, wobei die Lastimpedanz (62) einen ersten und einen zweiten Anschluss aufweist, wobei der erste Anschluss mit dem ersten Ausgang des Gleichstromisolators und der zweite Anschluss mit dem zweiten Ausgang des Gleichstromisolators elektrisch verbunden ist.

4. Signalpegelüberschreitungsdetektorschaltung nach Anspruch 3, wobei die Lastimpedanz eine parasitäre Impedanz umfasst.

5. Signalpegelüberschreitungsdetektorschaltung nach Anspruch 3 oder 4, wobei die Lastimpedanz, wenn sie in Form eines Kondensators ausgeführt ist, eine Kapazität von weniger als im Wesentlichen 500 pF hat.

6. Signalpegelüberschreitungsdetektorschaltung nach Anspruch 5, wobei die Kapazität zwischen im Wesentlichen 15 pF und im Wesentlichen 20 pF beträgt.

7. Signalpegelüberschreitungsdetektorschaltung nach einem der Ansprüche 3 bis 6, wobei die Lastimpedanz eine parasitäre Impedanz und/oder eine durch eine diskrete Komponente bereitgestellte Impedanz (46) umfasst.

8. Signalpegelüberschreitungsdetektorschaltung nach einem der Ansprüche 3 bis 7, wobei die Lastimpedanz einen dritten Kondensator (46) umfasst.

9. Signalpegelüberschreitungsdetektorschaltung nach Anspruch 8, wobei der erste, zweite und/oder dritte Kondensator (42, 44, 46) eine Kapazität von weniger als 100 pF hat.

10. Signalpegelüberschreitungsdetektorschaltung nach Anspruch 8, wobei der erste und der zweite Kondensator (42, 44, 46) jeweils eine Kapazität von weniger als 10 pF hat.

11. Signalpegelüberschreitungsdetektorschaltung nach einem der Ansprüche 8 bis 10, wobei der erste und/oder der zweite Kondensator (42, 44) ein diskreter Klasse-X-oder Klasse-Y-Kondensator und der dritte Kondensator (46) ein diskreter Keramikkondensator ist.

12. Signalpegelüberschreitungsdetektorschaltung nach einem der Ansprüche 8 bis 11, wobei die ersten und zweiten Platten des ersten (42), zweiten (44) und/oder dritten (46) Kondensators durch leitfähige Schichten einer Leiterplatte gebildet werden und das Dielektrikum des wenigstens einen Kondensators durch einen nicht leitfähigen Teil der Leiterplatte gebildet wird.

13. Signalpegelüberschreitungsdetektorschaltung nach Anspruch 12, wobei wenigstens eine Platte eines Kondensators (42, 44, 46) durch eine Metallschicht in oder auf der Leiterplatte gebildet wird.

14. Integrierte Schaltung, die die Signalpegelüberschreitungsdetektorschaltung (40, 60, 70) nach einem der vorhergehenden Ansprüche umfasst.

## Revendications

1. Circuit détecteur (40, 60, 70) de franchissement de niveau de signal comprenant :
un isolateur CC comprenant au moins une première entrée, qui est configuré pour recevoir un signal CA haute tension, et au moins un premier condensateur (42), une première plaque du premier condensateur (42) étant électriquement connectée à la première entrée ; et
un circuit détecteur (52) utilisable à basse tension et ayant au moins une première entrée de détecteur, la première entrée de détecteur étant électriquement connectée à une deuxième plaque du premier condensateur (42), le circuit détecteur (52) basse tension étant utilisable pour fournir un changement de signal de sortie en fonction d'un signal CA haute tension sur la première entrée franchissant un niveau de signal prédéterminé,
**caractérisé en ce que**
l'isolateur CC est un isolateur CC différentiel comprenant un deuxième condensateur (44), dans lequel une première plaque du deuxième condensateur (44) étant électriquement couplée à la deuxième entrée de l'isolateur CC et une deuxième plaque opposée du deuxième condensateur (44) étant électriquement connectée à une deuxième sortie.

2. Circuit détecteur (52) de franchissement de niveau de signal selon la revendication 1, dans lequel le circuit détecteur (52) est un détecteur différentiel ayant des première et deuxième entrées de détecteur, la première entrée de détecteur étant électriquement connectée à la première sortie de l'isolateur CC et la deuxième entrée de détecteur étant électriquement connectée à la deuxième sortie de l'isolateur CC.

3. Circuit détecteur (52) de franchissement de niveau de signal selon la revendication 2, dans lequel le circuit détecteur (52) de franchissement de niveau de signal comprend en outre une impédance de charge (62) électriquement connectée en série avec les premier et deuxième condensateurs (42, 44), l'impédance de charge (62) ayant des première et deuxième connexions, la première connexion étant électriquement connectée à la première sortie de l'isolateur CC et la deuxième connexion étant électriquement connectée à la deuxième sortie de l'isolateur CC.

4. Circuit détecteur de franchissement de niveau de signal selon la revendication 3, dans lequel l'impédance de charge comprend une impédance parasite.

5. Circuit détecteur de franchissement de niveau de signal selon la revendication 3 ou 4, dans lequel l'impédance de charge, lorsqu'elle est sous la forme d'un condensateur, a une capacitance de moins de sensiblement 500 pF.

6. Circuit détecteur de franchissement de niveau de signal selon la revendication 5, dans lequel la capacitance est entre sensiblement 15 pF et sensiblement 20 pF.

7. Circuit détecteur de franchissement de niveau de signal selon l'une quelconque des revendications 3 à 6, dans lequel l'impédance de charge comprend au moins une parmi une impédance parasite et une impédance (46) fournie par un composant discret.

8. Circuit détecteur de franchissement de niveau de signal selon l'une quelconque des revendications 3 à 7, dans lequel l'impédance de charge comprend un troisième condensateur (46).

9. Circuit détecteur de franchissement de niveau de signal selon la revendication 8, dans lequel au moins un parmi les premier, deuxième et troisième condensateurs (42, 44, 46) a une capacitance de moins de 100 pF.

10. Circuit détecteur de franchissement de niveau de signal selon la revendication 8, dans lequel chacun parmi les premier, deuxième et troisième condensateurs (42, 44, 46) a une capacitance de moins de 10 pF.

11. Circuit détecteur de franchissement de niveau de signal selon l'une quelconque des revendications 8 à 10, dans lequel au moins un parmi les premier et deuxième condensateurs (42, 44) est un condensateur discret de Classe X ou Y et le troisième condensateur (46) est un condensateur discret en céramique.

12. Circuit détecteur de franchissement de niveau de signal selon l'une quelconque des revendications 8 à 11, dans lequel les première et deuxième plaques d'au moins un parmi les premier (42), deuxième (44) et troisième (46) condensateurs sont définies par des couches conductrices d'une carte de circuits imprimés et le diélectrique de l'au moins un condensateur est défini par une partie non conductrice de la carte de circuits imprimés.

13. Circuit détecteur de franchissement de niveau de signal selon la revendication 12, dans lequel au moins une plaque d'un condensateur (42, 44, 46) est définie par une couche de métal dans ou sur la carte de circuits imprimés.

14. Circuit intégré comprenant le circuit détecteur (40, 60, 70) de franchissement de niveau de signal selon une quelconque revendication précédente.
